# EUROPEAN PATENT APPLICATION

(11) **EP 1 018 800 A1**
(43) Date of publication of application: **12.07.2000**
(21) Application number: 99310185.6
(22) Date of filing: 17.12.1999
(51) Int. Cl.: H03B 5/12

(54) **Local oscillation circuit**

(30) Priority: 06.01.1999 JP 136799
(71) Applicant: ALPS ELECTRIC CO., LTD., Ota-ku Tokyo 145 (JP)
(72) Inventor: Ogasawara, Yutaka, Soma-shi, Fukushima-ken (JP)
(74) Representative: Kensett, John Hinton

(57) **Abstract**

There will be provided a low-cost local oscillation circuit having simple structure, capable of reducing any phase noise in a local oscillation signal without externally connecting any lag-lead filter. A local oscillation circuit is composed of an amplification circuit (1) and a resonance circuit (2) connected to a feedback circuit of the amplification circuit, the resonance circuit has fixed inductors (2₁, 2₂), a varactor diode (2₃) to which tuning voltage is supplied through a feeding resistor (6), a damper resistor (2₅), a DC blocking capacitor (2₆), and a return resistor (2₈), which becomes a return circuit for the tuning voltage, a lag-lead filter (3) is formed by the feeding resistor (6), the damper resistor (2₅), the return resistor (2₈), and the DC blocking capacitor (2₆), and each resistance value of the feeding resistor (6), the damper resistor (2₅) and the return resistor (2₈) and a capacity value of the DC blocking capacitor (2₁₀) are selected in such a manner that a cut-off frequency of the lag-lead filter (3) becomes 1 to 20 kHz.

## Description

The present invention relates to a local oscillation circuit, and more particularly to a local oscillation circuit in which a resonance circuit having an inductor and a varactor diode is formed with a lag-lead filter having a low cut-off frequency, capable of eliminating any phase noise contained in a local oscillation signal without the aid of any lag-lead filter externally connected.

In recent years, in television broadcast, cable television and the like, the signal format has been changing from analog to digital, and as the signal modulation format to be utilized, a quadrature phase shift keying (QPSK) system, a quadrature amplitude modulation (QAM) system, an orthogonal frequency division multiplexing (OFDM) system, a vestigial sideband (VSB) modulation system and the like, which are unique to the digital signal format, have been adopted with the change in the signal format in place of the amplitude modulation (AM) system and the frequency modulation (FM) system which have been used as a usual practice in the analog signal format so far.

In this case, in an electronic tuner which receives a digital modulation signal modulated by a modulation system peculiar to the digital signal format, phase noise which has not been put in question at all in the modulation systems (AM and FM) of the conventional analog signal system, particularly phase noise, which is contained in a local oscillation signal generated by the local oscillation circuit, deteriorates phase noise of an intermediate frequency signal to be formed when a receiving signal and a local oscillation signal are mixed in a frequency mixer in the electronic tuner, and the deteriorated phase noise cannot be ignored in the intermediate frequency signal. Therefore, it has become necessary to reduce the phase noise contained in the local oscillation signal.

Generally, the electronic tuner for receiving a ground wave signal and a cable television (CATV) signal selects a channel having a receiving signal of a desired frequency by using a local oscillation signal generated by a voltage control type local oscillation circuit (VCO) provided within a phase-locked loop (PLL), and the local oscillation signal generated when the PLL is phase-locked contains phase noise.

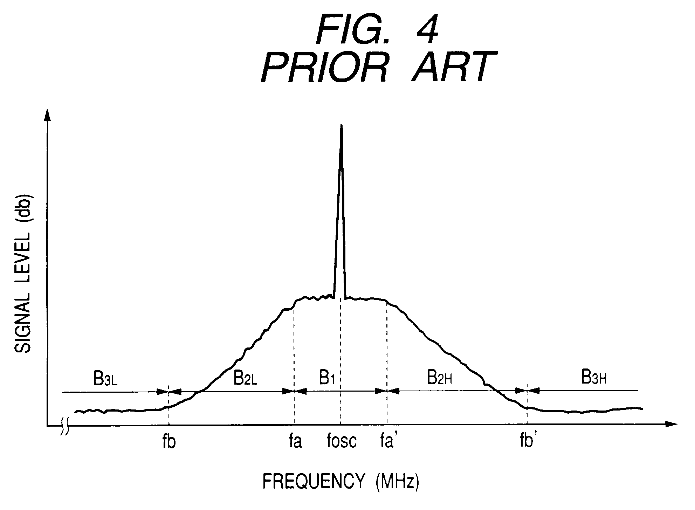

Fig. 4 is a characteristic diagram showing an example of a local oscillation signal to be outputted from the local oscillation circuit when the PLL of the aforesaid, known electronic tuner is phase-locked.

In Fig. 4, the abscissa indicates a frequency represented by MHz while the ordinate indicates a signal level represented by dB, and f_{OSC} is the frequency of a local oscillation signal, fa and fa', a lower cut-off frequency and an upper cut-off frequency in a PLL frequency band, and fb and fb', a lower detuning frequency and an upper detuning frequency respectively.

As shown in Fig. 4, phase noise contained in the local oscillation signal appears in a PLL frequency band B₁ between frequencies fa and fa', a lower side detuning frequency band B_{2L} between frequencies fa and fb, an upper side detuning frequency band B_{2H} between frequencies fa' and fb', a lower side detuning outside frequency band B_{3L} with a frequency fa' or less, and an upper side detuning outside frequency band B_{3H} with a frequency fb' or more.

In this case, phase noise generated within the PLL frequency band B₁ is mainly determined by the characteristic of a phase comparator within the PLL and the demultiply ratio of a PLL frequency demultiplier, and the PLL frequency band B₁ is normally is as very narrow a band as hundreds Hz to about 3 kHz.

Also, phase noise generated in the lower side detuning outside frequency band B_{3L} and the upper side detuning outside frequency band B_{3H} is mainly determined by a noise factor (NF) of the transistor within an amplification circuit, and is substantially constant depending upon the frequency. Therefore, this phase noise hardly deteriorates phase noise of an intermediate frequency signal.

In contrast, the lower side detuning frequency band B_{2L} and the upper side detuning frequency band B_{2H} are both as comparatively wide bands as several MHz, and therefore, this phase noise deteriorates the phase noise in the intermediate frequency signal. Accordingly, it is necessary to reduce this phase noise contained in the local oscillation signal.

As a known local oscillation circuit for reducing this phase noise contained in the local oscillation signal, there has been known a local oscillation circuit using a lag-lead filter externally connected to the resonance circuit in the local oscillation circuit.

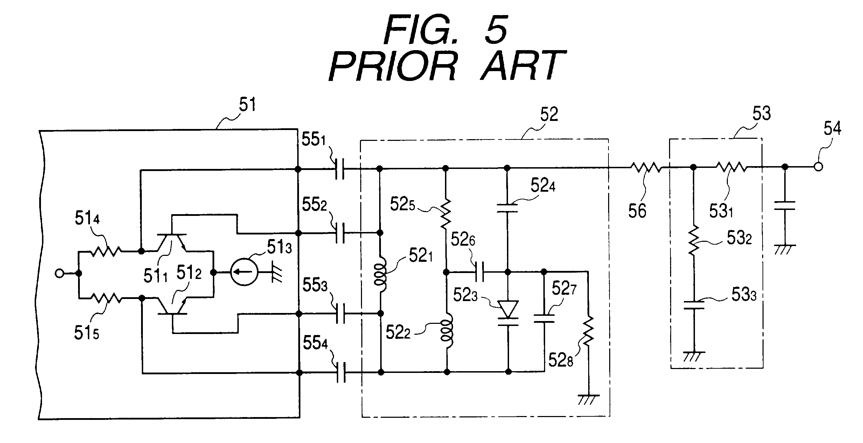

Fig. 5 is a circuit diagram showing an example of the structure of the aforesaid known local oscillation circuit, and shows only the structure of the principal part.

As shown in Fig. 5, the local oscillation circuit comprises, an amplification circuit 51 turned into an integrated circuit, a resonance circuit 52 connected to a feedback circuit of the amplification circuit 51, a lag-lead filter 53 connected to the resonance circuit 52, a tuning voltage input terminal 54, four coupling capacitors 55₁, 55₂, 55₃ and 55₄; and a feeding resistor 56.

In this case, the amplification circuit 51 has two transistors 51₁ and 51₂ balance-connected, an emitter current source 51₃ and two collector load resistors 51₄ and 51₅. The resonance circuit 52 has a first inductor 52₁, a second inductor 52₂, a varactor diode 52₃, a series capacitor 52₄, a damping resistor 52₅, a DC blocking capacitor 52₆, a by-pass capacitor 52₇, and a return resistor 52₈. The lag-lead filter 53 has a series resistor 53₃, a shunt resistor 53₂ and a shunt capacitor 53₃.

The amplification circuit 51 is connected to the resonance circuit 52 by four coupling capacitors 55₁ to 55₄, and the resonance circuit 52 is connected to the lag-lead filter 53 by the feeding resistor 56. Also, within the amplification circuit 51, the transistors 51₁ and 51₂, the emitter current source 51₃, and the collector load resistors 51₄ and 51₅ are connected as shown in Fig. 5. Within the resonance circuit 52, the first and second inductors 52₁ and 52₂, the varactor diode 52₃, the series capacitor 52₄, the damping resistor 52₅, the DC blocking capacitor 52₆, the by-pass capacitor 52₇, and the return resistor 52₈ are connected as shown in Fig. 5. Within the lag-lead filter 53, the series resistor 53₃, the shunt resistor 53₂ and the shunt capacitor 53₃ are connected as shown in Fig. 5, and the cut-off frequency is selected to be about 150 kHz.

The known local oscillation circuit having the aforesaid structure operates substantially as follows.

The resonance circuit 52 is connected to the feedback circuit between base and collector of transistors 51₁ and 51₂ in the amplification circuit 51 to form an oscillation circuit having an oscillation frequency to be determined by a reactance value presented by an oscillation frequency setting element of the resonance circuit 52. The oscillation frequency setting element in the resonance circuit 52 is mainly composed of the first and second inductors 52₁ and 52₂, the varactor diode 52₃, and the series capacitor 52₄, and its oscillation frequency is set by each inductance value of the first and second inductors 52₁ and 52₂, and each capacity value of the varactor diode 52₃ and the series capacitor 52₄. The capacity value of the varactor diode 52₃ is varied, whereby a local oscillation signal having a predetermined frequency is outputted from the local oscillation circuit.

More specifically, when DC tuning voltage is inputted into the tuning voltage input terminal 54, the tuning voltage is supplied to the resonance circuit 52 through the lag-lead filter 53 and the feeding resistor 56. In the resonance circuit 52, the tuning voltage is supplied to the cathode of the varactor diode 52₃ through the damping resistor 52₅ and the second inductor 52₂, and then is supplied to a grounded point from the anode of the varactor diode 52₃ through the return resistor 52₈. The capacity value of the varactor diode 52₃ is set by the tuning voltage supplied at this time, and a local oscillation signal having a predetermined frequency corresponding to the capacity value at the time is outputted from the local oscillation circuit.

In this case, the lag-lead filter 53 having a cut-off frequency of about 150 kHz is connected to the feeding circuit at the tuning voltage, whereby it is possible to reduce phase noise existing within the lower side detuning frequency band B_{2L} and the upper side detuning frequency band B_{2H} shown in Fig. 4, in the local oscillation signal to be outputted from the local oscillation circuit without degrading Q of the resonance circuit 52.

The aforesaid, known local oscillation circuit is capable of reducing phase noise within the lower side detuning frequency band B_{2L} and the upper side detuning frequency band B_{2H} in the local oscillation signal by connecting the lag-lead filter 53 having a cut-off frequency of about 150 kHz to the feeding circuit at the tuning voltage. Since, however, it is necessary to separately connect the lag-lead filter 53 to the feeding circuit at the tuning voltage, there are problems, among others, that the local oscillation circuit becomes complicated in structure, and that the manufacturing cost is increased and extra arrangement space must be prepared.

The present invention has been proposed to solve the above-described problems, and its object is to provide a low-cost local oscillation circuit having simple structure, capable of reducing any phase noise in a local oscillation signal without externally connecting any lag-lead filter.

In order to achieve the aforesaid object, a local oscillation circuit according to the present invention is composed of an amplification circuit and a resonance circuit connected to a feedback circuit of the amplification circuit. The resonance circuit has a varactor diode, to which the tuning voltage is supplied through the fixed inductor and the feeding resistor, a damper resistor, a DC blocking capacitor, and a return resistor which becomes a return circuit for the tuning voltage, and has means for forming a lag-lead filter having a cut-off frequency of 1 to 20 kHz by the feeding resistor, the damper resistor, the return resistor and the DC blocking capacitor.

According to the aforesaid means, various elements essentially required for constituting the resonance circuit, that is, each resistance value of the feeding resistor, the damper resistor and the return resistor and the capacity value of the DC blocking capacitor are selected to thereby form a lag-lead filter having a cut-off frequency of 1 to 20 kHz. Therefore, it does not become necessary to externally connect the lag-lead filter to the feeding circuit at the tuning voltage separately, on top of which a lag-lead filter of 1 to 20 kHz is formed, whereby it is possible to effectively reduce any phase noise contained in the local oscillation signal to be outputted from the local oscillation circuit without degrading Q of the resonance circuit, and to provide a low-cost local oscillation circuit in a simple circuit using no extra components.

Embodiments of the present invention will now be described by way of example only, with reference to the accompanying drawings, in which:
Fig. 1 is a circuit diagram showing the structure of a first embodiment for a local oscillation circuit according to the present invention;
Fig. 2 is a circuit diagram showing the structure of a second embodiment for a local oscillation circuit according to the present invention;
Fig. 3 is a circuit diagram showing the structure of a third embodiment for a local oscillation circuit according to the present invention;
Fig. 4 is a characteristic diagram showing an example of a local oscillation signal to be outputted from a local oscillation circuit when the PLL of a known electronic tuner is phase-locked; and
Fig. 5 is a circuit diagram showing an example of the structure of the known local oscillation circuit.

In a preferred embodiment, the local oscillation circuit is composed of an amplification circuit and a resonance circuit connected to a feedback circuit of the amplification circuit. The resonance circuit has a varactor diode, to which the tuning voltage is supplied through the fixed inductor and the feeding resistor, a damper resistor, a DC blocking capacitor, and a return resistor which becomes a return circuit for the tuning voltage. A lag-lead filter is formed by the feeding resistor, the damper resistor, the return resistor and the DC blocking capacitor, and each resistance value of the feeding resistor, the damper resistor and the return resistor and the capacity value of the DC blocking capacitor are selected in such a manner that the cut-off frequency of the lag-lead filter becomes 1 to 20 kHz.

Preferably, the local oscillation circuit comprises the damper resistor and the DC blocking capacitor connected in series to the varactor diode.

Alternatively, the local oscillation circuit comprises the damper resistor and the DC blocking capacitor connected in parallel to the varactor diode.

Preferably, the local oscillation circuit comprises a balance type amplification circuit whose amplification circuit is constructed of an integrated circuit.

According to these embodiments of the present invention, a lag-lead filter having a cut-off frequency of 1 to about 20 kHz is formed by utilizing the feeding resistor, the damper resistor, the return resistor and the DC blocking capacitor, which constitute the resonance circuit, as they are, and yet selecting each resistance value of the feeding resistor, the damper resistor and the return resistor and the capacity value of the DC blocking capacitor respectively. Therefore, it is not necessary to externally connect the lag-lead filter to the feeding circuit at the tuning voltage, and moreover, a lag-lead filter having a cut-off frequency of 1 to 20 kHz is formed, whereby it is possible to effectively reduce any phase noise within the lower side detuning frequency band and the upper side detuning frequency band, contained in the local oscillation signal to be outputted from the local oscillation circuit without degrading Q of the resonance circuit, and to manufacture a low-cost local oscillation circuit in a simple circuit using no extra components.

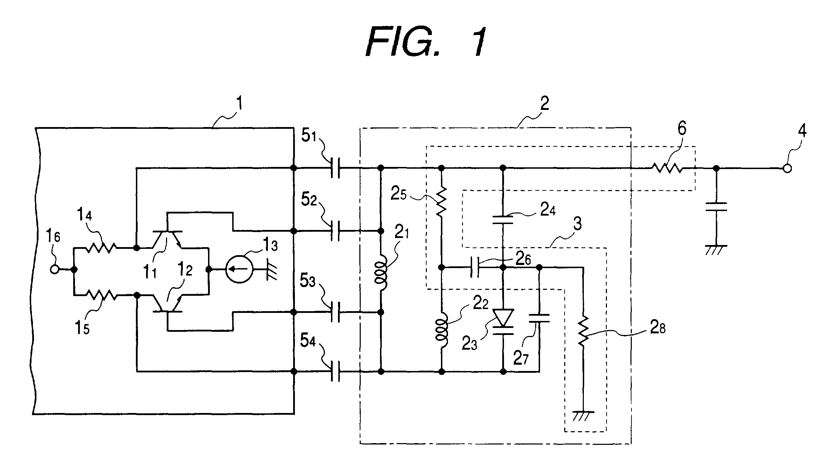

Fig. 1 is a circuit diagram showing the structure of a first embodiment for a local oscillation circuit according to the present invention, and shows only the structure of the principal part of the local oscillation circuit.

As shown in Fig. 1, a local oscillation circuit according to a first embodiment comprises: an amplification circuit 1 turned into an integrated circuit; a resonance circuit 2 connected to a feedback circuit of the amplification circuit 1; a lag-lead filter 3; a tuning voltage input terminal 4; four coupling capacitors 5₁, 5₂, 5₃ and 5₄; and a feeding resistor 6.

In this case, the amplification circuit 1 has two transistors 1₁ and 1₂ balance-connected; an emitter current source 1₃; two collector load resistors 1₄ and 1₅; and a power terminal 1₆. The resonance circuit 2 has a first inductor 2₁; a second inductor 2₂; a varactor diode 2₃; a series capacitor 2₄; a damper resistor 2₅; a DC blocking capacitor 2₆; a by-pass capacitor 2₇; and a return resistor 2₈. The lag-lead filter 3 has a damper resistor 2₅, a DC blocking capacitor 2₆, a return resistor 2₈, and a feeding resistor 6, which constitute the resonance circuit 2.

In the amplification circuit 1, a collector of the transistor 1₁ is connected to one end of a coupling capacitor 5₁ and one end of a collector load resistor 1₄, a base thereof is connected to one end of a coupling capacitor 5₂, and an emitter is connected to one end of an emitter current source 1₃. A collector of the transistor 1₂ is connected to one end of a coupling capacitor 5₄ and one end of a collector load resistor 1₅, a base is connected to one end of a coupling capacitor 5₃, and an emitter is connected to one end of the emitter current source 1₃. The other end of the emitter current source 1₃ is grounded, and each of other ends of the collector load resistors 1₄ and 1₅ is connected to a power terminal 1₆ respectively.

In the resonance circuit 2, one end of a first inductor 2₁ is connected to each of the other ends of the coupling capacitors 5₁ and 5₂, one end of a series capacitor 2₄, and one end of a damper resistor 2₅ respectively while the other end thereof is connected to each of the other ends of the coupling capacitors 5₃ and 5₄, one end of a second inductor 2₂, a cathode of a varactor diode 2₃, and one end of a by-pass capacitor 2₇ respectively. The other end of the second inductor 2₂ is connected to the other end of the damper resistor 2₅ and one end of a DC blocking capacitor 2₆ respectively. The anode of the varactor diode 2₃ is connected to the other end of the series capacitor 2₄, the other end of the DC blocking capacitor 2₆, the other end of the by-pass capacitor 2₇ and one end of the return resistor 2₈ respectively. The other end of the return resistor 2₈ is grounded.

In the lag-lead filter 3, one end of the feeding resistor 6 is connected to one end of the damper resistor 2₅, and the other end thereof is connected to the tuning voltage input terminal 4. The tuning voltage input terminal 4 is connected to one end of the shunt capacitor (having no reference numeral), and the other end of the shunt capacitor is grounded.

In this case, in the lag-lead filter 3, each resistance value of the feeding resistor 6, the damper resistor 2₅ and the return resistor 2₈ and the capacity value of the DC blocking capacitor 2₆ are respectively selected in such a manner that its cut-off frequency becomes a frequency within a range of 1 to 20 kHz, for example, 3.39 kHz. In order to select in such a manner that the cut-off frequency becomes, for example, 3.39 kHz, the integrated resistance value of the feeding resistor 6, the damper resistor 2₅ and the return resistor 28 can be selected to be 10 kΩ and the capacity value of the DC blocking capacitor 2₆ can be selected to be 4.7 µF.

A local oscillation circuit according to a first embodiment having the aforesaid structure operates as follows.

The resonance circuit 2 is connected to base-collector feedback circuits of the transistors 1₁ and 1₂ in the amplification circuit 1, and forms, together with the amplification circuit 1, an oscillation circuit having an oscillation frequency to be determined by a reactance value presented by the oscillation frequency setting element of the resonance circuit 2. The oscillation frequency setting element in the resonance circuit 2 is mainly composed of the first inductor 2₁, the second inductor 2₂, the varactor diode 2₃, and the series capacitor 2₄, and its oscillation frequency is set by each inductance value of the first inductor 2₁ and the second inductor 2₂, and each capacity value of the varactor diode 23 and the series capacitor 2₄. The capacity value of the varactor diode 23 is varied by the tuning voltage, whereby a local oscillation signal having a predetermined oscillation frequency is outputted from the local oscillation circuit.

When DC tuning voltage is inputted into the tuning voltage input terminal 4, the tuning voltage is supplied to the resonance circuit 2 through the feeding resistor 6. In the resonance circuit 2, the tuning voltage is supplied to the cathode of the varactor diode 2₃ through the damper resistor 2₅ and the second inductor 2₂, and then is supplied to a grounded point from the anode of the varactor diode 2₃ through a return resistor 2₈. At this time, the varactor diode 2₃ is reverse-biased by the tuning voltage supplied, and is set to a capacity value corresponding to the size of the reverse-bias voltage to output, from the local oscillation circuit, a local oscillation signal having a predetermined frequency corresponding to the capacity value set at that time.

Also, there is formed the lag-lead filter 3 selected in such a manner that the cut-off frequency becomes within a range of 1 to 20 kHz, for example, 3.39 kHz by the feeding resistor 6 arranged in the feeding circuit at the tuning voltage together with the damper resistor 2₅, the return resistor 2₈ and the DC blocking capacitor 2₆ which are arranged in the resonance circuit 2. Therefore, it is possible to reduce any phase noise existing within the lower side detuning frequency band B_{2L} and the upper side detuning frequency band B_{2H} shown in Fig. 4, superimposed on the local oscillation signal to be outputted from the local oscillation circuit without degrading Q of the resonance circuit 2. Then, the local oscillation signal to be outputted from the local oscillation circuit of the first embodiment and the receiving signal are frequency-mixed in a frequency mixer, and as a result, it is possible to effectively reduce undesirable phase noise which mixedly exists in an intermediate frequency signal obtained.

As described above, according to a local oscillation circuit of a first embodiment, without externally connecting any lag-lead filter in the feeding circuit separately, the lag-lead filter 3 is formed by the damper resistor 2₅, the return resistor 2₈ and the DC blocking capacitor 2₆ which have been essentially arranged in the resonance circuit 2, and the feeding resistor 6 essentially arranged within the feeding circuit. Therefore, it is possible to reduce any phase noise existing within the lower side detuning frequency band B_{2L} and the upper side detuning frequency band B_{2H}, superimposed on the local oscillation signal at low cost by a simple circuit configuration without necessitating any additional circuit components.

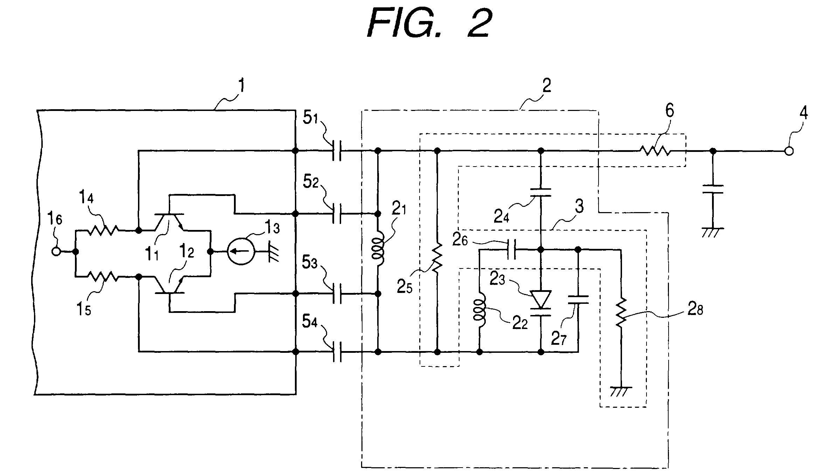

Fig. 2 is a circuit diagram showing the structure of a second embodiment of a local oscillation circuit according to the present invention, and likewise shows only the structure of the principal part of the local oscillation circuit.

In Fig. 2, components equivalent to those shown in Fig. 1 are represented by the same reference numerals.

The only difference in structure between this second embodiment and the aforesaid first embodiment is that as regards the connection position of the other end of the damper resistor 2₅ used in the resonance circuit 2, it is connected to the other end of the second inductor 2₂ in the first embodiment while it is connected to one end of the second inductor 2₂ in the embodiment, and in addition, there is no difference in structure between them. For this reason, a further description on the structure of the second embodiment will be omitted.

The operation of the second embodiment is substantially the same as that of the aforesaid first embodiment because they are substantially the same in the structure of the principal part, and the effect of operation obtained in the second embodiment is the same as that obtained in the first embodiment. Therefore, a further description on the operation of the second embodiment and the effect of the operation will be omitted.

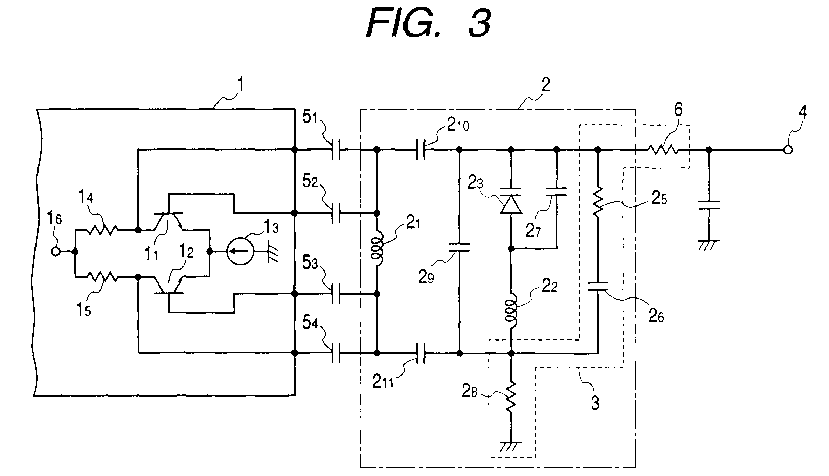

Fig. 3 is a circuit diagram showing the structure of a third embodiment for a local oscillation circuit according to the present invention, and likewise shows only the structure of the principal part of the local oscillation circuit.

As shown in Fig. 3, a resonance circuit 2 of the third embodiment is different from the first embodiment in that a parallel capacitor 2₉ is used in place of the series capacitor 2₄ of the first embodiment, and in that two coupling capacitors 2₁₀ and 2₁₁, which are not used in the first embodiment, are used. Also in this case, components equivalent to those shown in Fig. 1 are represented by the same reference numerals.

In the resonance circuit 2 of the third embodiment, one end of a first inductor 2₁ is connected to one end of a coupling capacitor 2₁₀, and the other end thereof is connected to one end of a coupling capacitor 2₁₁ respectively. One end of a second inductor 2₂ is connected to one end of the parallel capacitor 2₉, the other end of a coupling capacitor 2₁₁, one end of a DC blocking capacitor 2₆, and one end of a return resistor 2₈ respectively, and the other end thereof is connected to the anode of a varactor diode 2₃ and one end of a by-pass capacitor 2₇ respectively. The cathode of the varactor diode 2₃ is connected to the other end of the parallel capacitor 2₉, the other end of the coupling capacitor 2₁₀, the other end of the by-pass capacitor 2₇, one end of a damper resistor 2₅, and one end of a feeding resistor 6 respectively. The other end of the damper resistor 2₅ is connected to the other end of the DC blocking capacitor 2₆.

In a local oscillation circuit of the third embodiment having the aforesaid structure, an oscillation frequency setting element of the resonance circuit 2 is mainly composed of the first inductor 2₁, the second inductor 2₂, the varactor diode 2₃, and the parallel capacitor 2₉, and its oscillation frequency is set by each inductance value of the first inductor 2₁ and the second inductor 2₂, and each capacity value of the varactor diode 2₃ and the parallel capacitor 2₉. As in the case of the first embodiment, the capacity value of the varactor diode 2₃ is varied by the tuning voltage, whereby a local oscillation signal having a predetermined oscillation frequency is outputted from the local oscillation circuit.

In this case, when DC tuning voltage is inputted into the tuning voltage input terminal 4, the tuning voltage is supplied to the resonance circuit 2 through the feeding resistor 6. In the resonance circuit 2, the tuning voltage is directly supplied to the cathode of the varactor diode 2₃ and then is supplied to a grounded point from the anode of the varactor diode 2₃ through a return resistor 2₈. The varactor diode 2₃ is reverse-biased by the tuning voltage supplied, and is set to a capacity value corresponding to the size of the reverse-bias voltage to output, from the local oscillation circuit, a local oscillation signal having a predetermined frequency corresponding to the capacity value set at that time.

Also, there is formed the lag-lead filter 3 selected in such a manner that the cut-off frequency becomes within a range of 1 to 20 kHz, for example, 3.39 kHz by the feeding resistor 6 arranged in the feeding circuit at the tuning voltage together with the damping resistor 2₅, the return resistor 2₈ and the DC blocking capacitor 2₆ which are arranged in the resonance circuit 2. Therefore, as in the case of the local oscillation circuit of the first embodiment, it is possible to reduce any phase noise existing within the lower side detuning frequency band B_{2L} and the upper side detuning frequency band B_{2H} shown in Fig. 4, superimposed on the local oscillation signal to be outputted from the local oscillation circuit without degrading Q of the resonance circuit 2.

As described above, even in a local oscillation circuit of the third embodiment, without externally connecting any lag-lead filter in the feeding circuit separately, the lag-lead filter 3 is formed by the damper resistor 2₅, the return resistor 2₈ and the DC blocking capacitor 2₆ which have been essentially arranged in the resonance circuit 2, and the feeding resistor 6 essentially arranged within the feeding circuit. Therefore, it is possible to reduce any phase noise existing within the lower side detuning frequency band B_{2L} and the upper side detuning frequency band B_{2H}, superimposed on the local oscillation signal at low cost by a simple circuit configuration without necessitating any additional circuit components.

In this respect, in each of the aforesaid embodiments, the description has been made of the example in which the cut-off frequency of the lag-lead filter 3 is 3.39 kHz, and the cut-off frequency of the lag-lead filter according to the present invention is not limited to the case of 3.39 kHz, and the similar effect of operation can be achieved even if any cut-off frequency is selected so long as it is within a range of 1 to 20 kHz.

Also, in each of the aforesaid embodiments, the description has been made of the example in which the amplification circuit 1 is a balance type circuit turned into an integrated circuit, and the amplification circuit 1 according to the present invention is not limited to the one having such structure, but it goes without saying that another circuit constructed of individual components can be used so long as the local oscillation circuit can be constituted together with the resonance circuit 2.

As described above, a lag-lead filter having a cut-off frequency of 1 to about 20 kHz has been formed by utilizing the feeding resistor, the damper resistor, the grounding resistor and the DC blocking capacitor, which constitute the resonance circuit, as they are, and yet selecting each resistance value of the feeding resistor, the damper resistor and the grounding resistor and the capacity value of the DC blocking capacitor respectively. Therefore, it is not necessary to externally connect the lag-lead filter to the feeding circuit at the tuning voltage, and moreover, a lag-lead filter having the cut-off frequency of 1 to 20 kHz has been formed, whereby there are the effects that it is possible to effectively reduce any phase noise within the lower side detuning frequency band and the upper side detuning frequency band, contained in the local oscillation signal to be outputted from the local oscillation circuit without degrading Q of the resonance circuit, and to manufacture a low-cost local oscillation circuit in a simple circuit using no extra components.

## Claims

1. A local oscillation circuit composed of an amplification circuit and a resonance circuit connected to a feedback circuit of said amplification circuit, said resonance circuit having a fixed inductor, a varactor diode to which tuning voltage is supplied through a feeding resistor, a damper resistor, a DC blocking capacitor, and a return resistor which becomes a return circuit for said tuning voltage, a lag-lead filter being formed by said feeding resistor, said damper resistor, said return resistor, and said DC blocking capacitor, and each resistance value of said feeding resistor, said damper resistor and said return resistor and a capacity value of said DC blocking capacitor being elected in such a manner that a cut-off frequency of said lag-lead filter becomes 1 to 20 kHz.

2. The local oscillation circuit according to Claim 1, wherein said damper resistor and said DC blocking capacitor are connected in series to said varactor diode.

3. The local oscillation circuit according to Claim 1, wherein said damper resistor and said DC blocking capacitor are connected in parallel to said varactor diode.

4. The local oscillation circuit according to Claims 1 to 3, wherein said amplification circuit is a balance type amplification circuit constructed of an integrated circuit.
